# EUROPÄISCHE PATENTANMELDUNG

(11) **EP 3 373 052 A1**
(43) Veröffentlichungstag der Anmeldung: **12.09.2018**
(21) Anmeldenummer: 17159462.5
(22) Anmeldetag: 06.03.2017
(51) Int. Cl.: G02B 6/13, C30B 25/20

(54) **HALBZEUG, VERFAHREN ZU DESSEN HERSTELLUNG UND DAMIT HERGESTELLTE KOMPONENTE**

(71) Anmelder: Fraunhofer-Gesellschaft zur Förderung der angewandten Forschung e.V., 80686 München (DE)
(72) Erfinder: GIESE, Christian, 79115 Freiburg (DE); NEBEL, Christoph. E., 79102 Freiburg (DE)
(74) Vertreter: Friese Goeden Patentanwälte PartGmbB

(57) **Zusammenfassung**

Die Erfindung betrifft ein Halbzeug (1) mit einem Substrat (10) mit einer ersten Seite (11) und einer gegenüberliegenden zweiten Seite (12), wobei auf der ersten Seite zumindest eine Diamantschicht (20) angeordnet ist, wobei die Diamantschicht (20) einkristallinen Diamant enthält oder daraus besteht und das Substrat (10) ein von der Diamantschicht (20) verschiedenes Material enthält oder daraus besteht. Weiterhin betrifft die Erfindung ein Verfahren zur Herstellung eines solchen Halbzeuges und eine aus dem Halbzeug hergestellte integrierte optische Komponente.

## Beschreibung

Die Erfindung betrifft ein Halbzeug mit einem Substrat mit einer ersten Seite und einer gegenüberliegenden zweiten Seite, wobei auf der ersten Seite zumindest eine Diamantschicht angeordnet ist. Weiterhin betrifft die Erfindung

Aus N. Gruhler et al.: Diamaond on aluminium nitride as a platform for integrated photonic circuits, Phys. Stat. Sol A (2016) Vol. 213, Issue 8, Seiten 207-2080 ist bekannt, eine polykristalline Diamantschicht heteroepitaktisch aus der Gasphase abzuscheiden und nachfolgend durch Strukturieren und Ätzen Wellenleiter aus Diamant als Teil integrierter optischer Komponenten zu erzeugen.

Nachteilig an dieser bekannten optischen Komponente ist jedoch die starke Dämpfung optischer Signale durch die große Anzahl an Kristallfehlern des polykristallinen Diamant. Für technische Anwendungen werden daher Wellenleiter integrierter optischer Komponenten aus anderen Materialien hergestellt, beispielsweise SiO₂, ZnSe oder Ge. Diese Materialien weisen jedoch den Nachteil auf, dass der Brechungsindex wesentlich niedriger ist als im Falle von Diamant. Weiterhin sind die Bandlücken dieser Materialien erheblich kleiner, so dass Licht kürzerer Wellenlängen aufgrund der Erzeugung von Elektron-Loch-Paaren eine starke Absorption erfährt. Schließlich führt auch die Erwärmung zur Erzeugung freier Ladungsträger, so dass die bekannten Materialien bei hohen Temperaturen ihre Transparenz auch für infrarotes Licht verlieren.

Ausgehend vom Stand der Technik liegt der Erfindung somit die Aufgabe zugrunde, ein Halbzeug zur Herstellung integrierter optischer Komponenten anzugeben, welches eine geringe Dämpfung optischer Sigale und einen hohen Brechungsindex aufweist sowie für Hochtemperaturanwendungen geeignet ist.

Die Aufgabe wird erfindungsgemäß durch ein Halbzeug gemäß Anspruch 1, eine Komponente nach Anspruch 8 und ein Verfahren nach Anspruch 10 gelöst. Vorteilhafte Weiterbildungen der Erfindung finden sich in den Unteransprüchen.

Erfindungsgemäß wird ein Halbzeug mit einem Substrat mit einer ersten Seite und einer gegenüberliegenden zweiten Seite vorgeschlagen. Das Substrat kann beispielsweise ein Oxid und/oder ein Nitrid und/oder Siliziumoxid und/oder Siliziumnitrid und/oder Siliziumoxinitrid und/oder Siliziumcarbid und/oder Silizium und/oder Saphir und/oder Glas und/oder einen III-VI-Verbindungshalbleiter und/oder Aluminiumnitrid enthalten oder daraus bestehen. Das Substrat kann homogen aufgebaut sein, d.h. nur aus einer einzigen Materiallage bestehen. In anderen Ausführungsformen der Erfindung kann das Substrat selbst aus mehreren Einzelschichten zusammengesetzt sein. In einigen Ausführungsformen der Erfindung kann das Substrat eine laterale Strukturierung aufweisen und als integrierter elektronischer Schaltkreis ausgebildet sein bzw. einen integrierten Schaltkreis enthalten.

Auf der ersten Seite des Substrates ist zumindest eine Schicht angeordnet, welche einkristallinen Diamant enthält oder daraus besteht. Der einkristalline Diamant enthält gegenüber bekanntem polykristallinen Diamant eine geringere Anzahl von Kristalldefekten, z.B. Korngrenzen, Versetzungen, Phasengrenzflächen, Einschlüsse oder andere Defekte. Dies vermindert die Streuung und/oder Brechung des innerhalb des Diamant propagierenden Lichtes, so dass sich optische Signale mit geringerer Dämpfung ausbreiten können.

Diamant ist ein Halbleiter mit einer Bandlücke von etwa 5,5 eV. Dies erlaubt einerseits, auch kurzwellige optische Signale aus dem sichtbaren oder nah-ultravioletten Spektrum in entsprechenden optischen Komponenten zu verwenden. Darüber hinaus werden Minoritätsladungsträger auch bei hohen Temperaturen nur in sehr geringem Umfang erzeugt, so dass Diamant auch bei hohen Einsatztemperaturen seine Transparenz beibehält. Schließlich weist Diamant einen sehr hohen Brechungsindex von etwa 2,4 auf. Dadurch können integrierte optische Komponenten auf der Basis des erfindungsgemäßen Halbzeuges eine verbesserte Leistungsfähigkeit und/oder einen breiteren Einsatzbereich aufweisen als bekannte optische Komponenten auf der Basis von Germanium, Zinkselenid oder Saphir.

Erfindungsgemäß wird vorgeschlagen, zur Herstellung des Halbzeuges die Diamantschicht homoepitaktisch auf einem Hilfssubstrat aus Diamant abzuscheiden und nachfolgend vom Hilfssubstrat zu trennen und ein- oder doppelseitig auf das Substrat aufzubringen. Dies vermeidet bei der Abscheidung des Diamant aus der Gasphase eine Gitterfehlanpassung zwischen Hilfssubstrat bzw. Substrat und Diamantschicht, so dass die Kristallqualität wie vorstehend beschrieben verbessert ist.

Das erfindungsgemäße Halbzeug kann durch nachfolgendes Strukturieren zu integrierten optischen Komponenten weiterverarbeitet werden. Das Strukturieren der Diamantschicht auf dem Substrat kann durch maskieren und anschließendes nass- oder trockenchemisches Ätzen erfolgen. Alternativ kann das Strukturieren der Diamantschicht durch Lasermaterialbearbeitung erfolgen.

Durch das Strukturieren der Diamantschicht kann zumindest ein mikrooptisches Bauelement gebildet werden. Dieses kann in einigen Ausführungsformen der Erfindung ausgewählt sein aus einem Wellenleiter und/oder einem Laser und/oder einem Verstärker und/oder einem Multimode-Interference-Coupler (MMI) und/oder einem Mischer und/oder einem Frequenzvervielfacher und/oder einem optisch-parametrischen Oszillator und/oder einem Interferometer und/oder einem Arrayed-Waveguide-Grating (AWG). In einigen Ausführungsformen der Erfindung kann eine Mehrzahl solcher Komponenten auf einem Substrat angeordnet sein, um komplexe Funktionen der optischen Mess- oder Nachrichtentechnik oder der Metrologie auszuführen. In einigen Ausführungsformen der Erfindung können mikrooptische Komponenten zusammen mit mikroelektronischen und/oder mikromechanischen Komponenten integriert werden, um die Funktionsvielfalt des so erzeugten Bauelementes weiter zu erhöhen. Da die Herstellung mit etablierten Techniken der Mikroelektronik erfolgen kann, ist eine Integration des Herstellungsverfahrens in vorhandene Prozessketten einfach möglich.

Beispielsweise kann durch das Strukturieren der Diamantschicht ein Wellenleiter erzeugt werden. Der Wellenleiter kann als Multimode-Wellenleiter und/oder als Singlemode-Wellenleiter ausgebildet sein. Der Wellenleiter enthält zumindest einen Kern. Der Kern ist von einem weiteren Material mit geringerem Brechungsindex umgeben. Dies kann aufgrund des hohen Brechungsindex von Diamant auch Umgebungsluft oder ein Schutzgas sein. Optische Signale werden an den Grenzflächen des Kerns totalreflektiert und auf diese Weise im Inneren des Wellenleiters entlang dessen Längserstreckung geführt. In gleicher Weise können auch komplexere Bauelemente realisiert werden.

In einigen Ausführungsformen der Erfindung kann das Erzeugen von zumindest einem Wellenleiter durch Strukturieren der Diamantschicht mittels Maskieren mit einer metallischen Maske und anschließendes Plasmaätzen erfolgen. Dadurch lassen sich Singlemode- und Multimode-Wellenleiter an genau definierten Stellen des Substrates erzeugen, so dass eine definierte Geometrie des Halbzeugs hergestellt werden kann.

Anfang und Ende des Wellenleiters können mit je einem Koppelelement versehen werden, welches die Einkopplung optischer Signale aus einer Faseroptik oder einem Freistrahl ermöglicht. Alternativ können Lichtquellen und/oder Detektoren auch auf dem Substrat integriert sein, beispielsweise Photodioden, CCD-Sensoren, CMOS-Sensoren, Halbleiterlaser, Leuchtdioden und/oder Superlumineszenzdioden.

In einigen Ausführungsformen der Erfindung kann die Diamantschicht des Halbzeuges eine Dicke von etwa 1 µm bis etwa 6 µm oder von etwa 2 µm bis etwa 5 µm aufweisen. Hierdurch können auch Singlemode-Wellenleiter hergestellt werden.

In einigen Ausführungsformen der Erfindung kann die Diamantschicht des Halbzeuges eine Fläche zwischen etwa 450 mm³ und etwa 45000 mm³ oder zwischen etwa 1500 mm³ und etwa 20000 mm³ oder zwischen etwa 1900 mm³ und etwa 7900 mm³ aufweisen. Da die erfindungsgemäß verwendete Diamantschicht in einigen Ausführungsformen der Erfindung aus der Gasphase abgeschieden wird, ist die Größe des Halbzeuges nicht auf die Größe typisch vorkommender natürlicher Diamant-Einkristalle beschränkt.

In einigen Ausführungsformen der Erfindung kann zwischen dem Substrat und der Diamantschicht eine Isolationsschicht angeordnet sein. Der Isolator kann einen spezifischen Widerstand zwischen etwa 10⁷ Ω·cm und etwa 10¹⁶ Ω·cm aufweisen. Die Isolationsschicht kann zusätzlich auch chemisch inert sein und auf diese Weise eine weitere Oxidation des Substrates verhindern. Hierdurch wird der erfindungsgemäße Halbzeug langzeitstabil und eine Beeinflussung elektrischer bzw. elektronischer Komponenten auf bzw. im Substrat wird vermieden. Darüber hinaus kann die Isolationsschicht in einigen Ausführungsformen der Erfindung auch die Haftfestigkeit zwischen der Diamantschicht und dem Substrat verbessern.

Die Isolationsschicht kann durch Sputtern, Aufdampfen oder CVD-Verfahren erzeugt werden. Hierdurch ist eine gute Kontrolle der Zusammensetzung und damit der chemischen, elektrischen und mechanischen Eigenschaften gegeben.

In einigen Ausführungsformen der Erfindung kann im Substrat zumindest ein mikroelektronisches Bauelement angeordnet sein. Ein solches Bauelement kann in einigen Ausführungsformen der Erfindung ausgewählt sein aus zumindest einer Leiterschleife und/oder zumindest einer Antenne und/oder zumindest einem Transistor und/oder zumindest einer Kapazität und/oder zumindest einem Widerstand und/oder zumindest einem optoelektronischen Bauteil. Ein solches Bauelement bzw. eine Mehrzahl von Bauelementen als integrierte Schaltung innerhalb des Substrates kann zur Signalerzeugung, zur Signalauslese oder zur Signalanalyse dienen. Beispielsweise kann auf dem Substrat eine Lichtquelle bzw. ein Lichtdetektor integriert sein, beispielsweise ein Halbleiterlaser, eine Leuchtdiode, eine Photodiode oder ein CCD-Detektor.

In einigen Ausführungsformen der Erfindung kann die Verbindung zwischen der Diamantschicht und dem Substrat durch direktes Waferbonden bzw. Van-der-Waals-Kräfte oder oberflächenaktiviertes Bonden oder Plasma-aktiviertes Bonden oder Löten oder Kleben hergestellt sein. Hierzu können die Oberflächen der Diamantschicht und/oder des Substrates auf eine geringe Rauheit von weniger als 50 nm oder weniger als 10 nm oder weniger als 2 nm poliert werden. Dies kann durch mechanisches polieren und/oder Plasmaätzen bzw. Plasmapolieren erfolgen. Als Ätzmittel kann ein Plasmaverwendet werden, welches Sauerstoff enthält. Alternativ kann ein Plasma verwendet werden, welches Sauerstoff und Argon enthält.

In einigen Ausführungsformen der Erfindung kann die Diamantschicht vor dem Ablösen vom Hilfs¬substrat auf einem Träger befestigt werden. Der Träger kann durch Wachs oder Klebstoff oder Löten befestigt werden. Dadurch wird die Handhabung der Diamantschicht währed des Transfers auf das Substrat erleichtert.

Der Träger kann durch Erwärmen des Substrates mit der darauf angeordneten Diamantschicht entfernt werden. In einigen Ausführungsformen der Erfindung kann die Oberfläche der Diamantschicht danach einem Reinigungsschritt unterzogen werden.

Nachfolgend soll die Erfindung anhand von Figuren ohne Beschränkung des allgemeinen Erfindungsgedankens näher erläutert werden. Dabei zeigt
Figur 1 eine schematische Darstellung einer integrierten optischen Komponente in der Ansicht.
Figur 2 zeigt eine schematische Darstellung einer integrierten optischen Komponente im Schnitt.
Figuren 3 bis 9 erläutern Verfahrensschritte zur Herstellung eines erfindungsgemäßen Halbzeuges.
Figuren 10 bis 15 erläutern Verfahrensschritte zur Herstellung einer integrierten optischen Komponente aus einem erfindungsgemäßen Halbzeug.

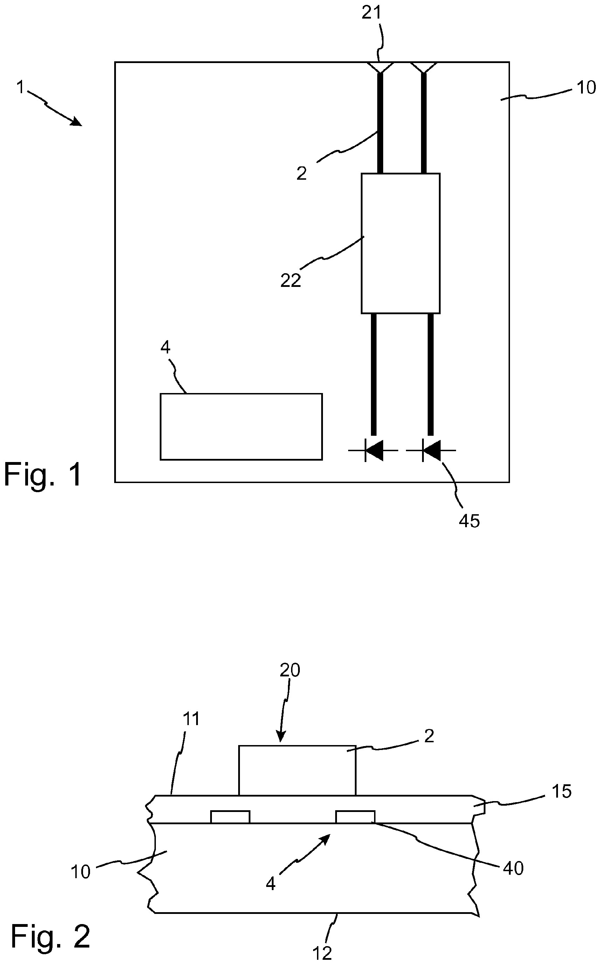

Anhand der Figur 1 wird eine schematische Darstellung einer integrierten optischen Komponente in der Ansicht erläutert. Figur 2 zeigt einen Ausschnitt aus dem Querschnitt durch diese integrierte optische Komponente.

Figuren 1 und 2 zeigen ein Substrat 10, welches beispielsweise Silizium, eine Oxidkeramik, ein Nitrid oder einen III-V-Verbindungshalbleiter enthalten kann. Das Substrat 10 kann selbst wiederum aus einer Mehrzahl von Einzelschichten zusammengesetzt und optional auch lateral strukturiert sein, so dass das Substrat 10 auch eine mikromechanische Komponente oder eine integrierte elektronische Schaltung 4 enthalten kann. Beispielsweise kann eine Lichtquelle oder ein Lichtempfänger 45 auf dem Substrat 10 integriert sein. Daneben kann das Substrat 10 selbstverständlich weitere elektronische Komponenten enthalten, beispielsweise ein Spektrometer, einen Verstärker, einen Diskriminator, einen A/D-Wandler oder weitere, an sich bekannte Komponenten.

Das Substrat 10 weist eine erste Seite 11 und eine gegenüberliegende zweite Seite 12 auf. Im dargestellten Ausführungsbeispiel ist eine Diamantschicht 20 auf der ersten Seite 11 angeordnet. In anderen Ausführungsformen der Erfindung kann die Diamantschicht 20 auch auf der zweiten Seite oder beidseitig aufgebracht werden.

Zwischen der Diamantschicht 20 und dem Substrat 10 befindet sich eine Isolationsschicht 15. Die Isolationsschicht 15 kann beispielsweise ein Nitrid, ein Oxid oder ein Oxynitrid enthalten. Diese kann eine elektrische Isolation zwischen Substrat und Wellenleiter 2 bewirken, die Haftfestigkeit der Wellenleiter 2 auf dem Substrat 10 sicherstellen oder weitere, hier nicht näher genannte Aufgaben übernehmen. Es ist darauf hinzuweisen, dass die Isolationsschicht 15 optional ist und in anderen Ausführungsformen der Erfindung auch entfallen kann.

Die Diamantschicht 20 wurde danach lateral strukturiert, um Wellenleiter 2 und einen Multimode-Interference-Coupler 22 auf dem Substrat 10 zu erzeugen. Dargestellt ist ein 2x2-MMI, welcher optische Signale aus den Eingangswellenleitern mischt und in die Ausgangswellenleiter überführt. In anderen Ausführungsformen der Erfindung können andere optische Bauelemente erzeugt werden. Die Darstellung ist lediglich beispielhaft zu verstehen.

Die Wellenleiter 2 weisen jeweils eine Dicke von etwa 1 µm bis etwa 5 µm auf. Die Breite der Wellenleiter ist so gewählt, dass diese entweder als Singlemode-Wellenleiter oder als Multimode-Wellenleiter ausgeführt sind. Hierdurch kann Licht vorgebbarer Wellenlängen gefiltert werden. Dies kann das Signal-/Rauschverhältnis positiv beeinflussen.

Die Eingangswellenleiter 2 enden an jeweils zumindest einem zugeordneten Koppelelement 21, über welches Licht einer an sich bekannten Lichtquelle eingekoppelt werden kann. Die Lichtquelle kann beispielsweise ein Halbleiterlaser, eine Superlumineszenzdiode, eine Leuchtdiode oder eine andere, an sich bekannte Lichtquelle oder eine Faseroptik umfassen. Die Lichtquelle kann in einigen Ausführungsformen Licht mit einer Wellenlänge zwischen etwa 2500 und etwa 300 nm aussenden. In einigen Ausführungsformen der Erfindung kann die Lichtquelle Licht mit einer Wellenlänge von etwa 1600 nm bis etwa 500 nm bzw. Licht mit einer Wellenlänge von etwa 800 nm bis etwa 550 nm aussenden.

Weiterhin zeigen die Figuren ein elektronisches Bauelement 4, welches innerhalb des Substrates 10 oder auf dessen unmittelbarer Oberfläche angeordnet und in der Isolationsschicht 15 eingebettet sein kann. Im dargestellten Ausführungsbeispiel umfasst das Bauelement 4 einen integrierten Schaltkreis zur Signalauslese und/oder Dekodierung sowie Leiterbahnen 40, welche aus einem elektrisch leitfähigen Material hergestellt sind. Beispielsweise können die Leiterbahnen 40 ein Metall oder eine Legierung enthalten, welche auf dem Substrat 10 abgeschieden und nachfolgend durch Maskieren und Ätzen strukturiert wurden.

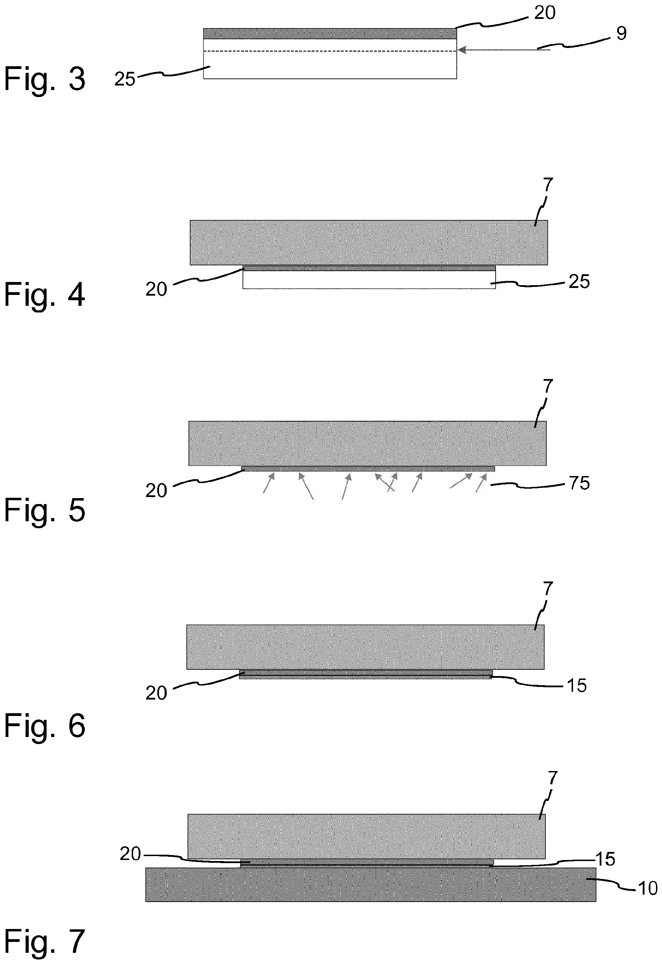

Anhand der Figuren 3 bis 9 werden Verfahrensschritte erläutert, welche die Herstellung eines erfindungsgemäßen Halbzeugs ermöglichen. Das Herstellungsverfahren ist dabei beispielhaft zu sehen. Selbstverständlich kann der vorgeschlagene Halbzeug auch in anderer Weise hergestellt werden.

Figur 3 erläutert die Herstellung von Diamant 20 auf einem Hilfssubstrat 25. Im dargestellten Ausführungsbeispiel ist das Hilfssubstrat 25 ein einkristalliner Diamant. Der Diamant 20, welcher später die Schicht 20 bildet, kann auf dem Hilfssubstrat 25 homoepitaktisch aus der Gasphase abgeschieden werden. Hierzu stehen mehrere, an sich bekannte Verfahren zur Verfügung. Beispielsweise kann die Diamantschicht 20 durch Hot-Filament-CVD oder durch Plasmaenhanced-CVD erzeugt werden. Diese Verfahren sind dem Fachmann geläufig. Die Erfindung lehrt nicht die Verwendung eines speziellen Herstellungsverfahrens für Diamant 20 als Lösungsprinzip.

Durch die homoepitaktische Abscheidung auf Diamant weist die Diamantschicht 20 keine Gitterfehlanpassung zum Hilfssubstrat 25 auf, so dass die Kristallqualität verbessert ist.

Nachfolgend wird die Diamantschicht 20 vom Hilfssubstrat 25 getrennt. Dies kann beispielsweise durch Laserstrahlung 9 erfolgen, welche die Bindungen innerhalb des Hilfssubstrates 25 oder innerhalb der Diamantschicht 20 aufbricht und einen Trennschnitt erzeugt.

Zur Weiterverarbeitung der Diamantschicht 20 wird diese auf einen Träger 7 befestigt. Dies wird in Figur 4 dargestellt. Die Befestigung auf dem Träger 7 kann beispielsweise mit einem Wachs, einem Epoxidharz, einem Lot oder einem anderen, an sich bekannten Bindemittel erfolgen. Der Träger 7 kann beispielsweise ein Silizium-Wafer sein oder einen solchen enthalten. In anderen Ausführungsformen der Erfindung eignet sich für den Träger 7 auch jede andere plane Materiallage aus einem Metall, einer Legierung, einer Keramik oder einem Glas. Der Träger kann in einigen Ausführungsformen der Erfindung auch vor dem Erzeugen des Trennschnittes 9 aufgebracht werden.

Figur 5 zeigt den nächsten Verfahrensschritt, nämlich das vollständige Entfernen des Hilfssubstrates 25 und/oder das Dünnen der Diamantschicht 20. Hierzu wird ein nass- oder trockenchemisches Ätzen verwendet, wobei ein Ätzmittel 75 auf die nicht vom Träger 7 bedeckte Oberfläche der Diamantschicht einwirkt und auf diese Weise das Hilfssubstrat 25 vollständig entfernt. Es ist darauf hinzuweisen, dass alternativ zum dargestellten Ätzverfahren das Entfernen des Hilfssubstrates 25 auch dadurch erfolgen kann, dass der in Figur 7 gezeigte Trennschnitt näher an der Oberfläche des Hilfssubstrates 25 oder sogar innerhalb der Diamantschicht 20 erfolgen kann. In anderen Ausführungsformen der Erfindung kann das Hilfssubstrat 25 auch spanend entfernt werden, beispielsweise durch Schleifen bzw. Polieren. In einigen Ausführungsformen der Erfindung kann das Hilfssubstrat 25 auch ganz oder teilweise an der Diamantschicht 20 verbleiben.

Durch die Einwirkung des Ätzmittels 75 kann die Oberfläche der Diamantschicht 20 eine Rauheit von weniger als 50 nm oder weniger als 10 nm oder weniger als 2 nm RMS aufweisen.

Nachdem das Hilfssubstrat 25 entfernt wurde, wird auf die freie Oberfläche der Diamantschicht 20 optional eine Isolationsschicht 15 aufgebracht. Dies ist anhand von Figur 6 erläutert. Die Isolationsschicht 15 kann beispielsweise Siliziumoxid enthalten. Eine solche Isolationsschicht kann durch einen Sputterprozess aus der Gasphase abgeschieden werden. In anderen Ausführungsformen der Erfindung können neben Sputterverfahren auch andere, an sich bekannte Verfahren zur Schichtabscheidung verwendet werden, beispielsweise Chemical Vapor Deposition oder Physical Vapor Deposition. In wiederum anderen Ausführungsformen der Erfindung kann die Isolationsschicht 15 auch auf das Substrat 10 aufgebracht werden oder entfallen. Die Isolationsschicht 15 kann selbst wiederum ein Schichtsystem aus einer Mehrzahl von Einzelschichten sein.

Figur 7 zeigt das Aufbringen eines Substrates 10 auf die Isolationsschicht 15. Das Substrat 10 kann beispielsweise durch Waferbonden mit der Isolationsschicht 15 verbunden werden. Dies führt zur Ausbildung von Van-der-Waals-Kräften zwischen der ersten Seite 11 des Substrates 10 und der Diamantschicht 20.

In anderen Ausführungsformen der Erfindung kann selbstverständlich die Isolationsschicht 15 auch zunächst auf das Substrat 10 aufgebracht und dann auf die Diamantschicht 20 gebondet werden. Erfindungswesentlich ist eine Verbindung zwischen der Diamantschicht 20 und dem Substrat 10 mit oder ohne dazwischen angeordnete Isolationsschicht 15. Zur Erreichung dieses Zieles sind dem Fachmann eine Vielzahl von Verfahren geläufig, beispielsweise auch plasma-aktiviertes Bonden, Oberflächenaktiviertes Bonden oder auch die Verwendung von Klebstoffen oder Loten.

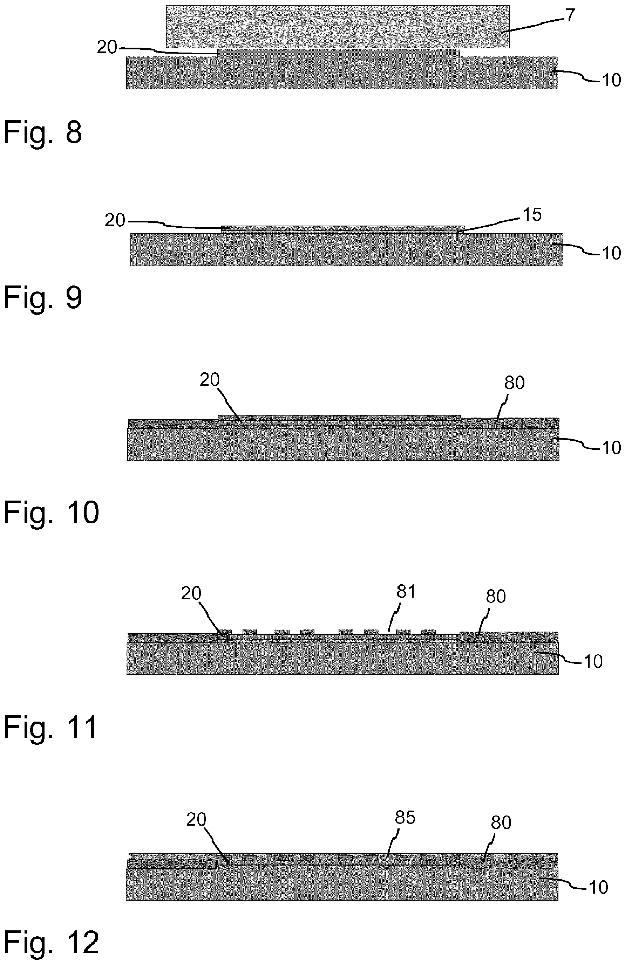

Figur 8 zeigt das Aufbringen eines Substrates 10 unmittelbar auf die Diamantschicht 20, ohne eine dazwischen angeordnete Isolationsschicht 15. Dieses Vorgehen kann vorteilhaft sein, wenn das Substrat 10 ohnehin aus einem Isolator besteht oder wenn das Substrat 10 keine ekeltronischen Bauelemente enthält.

Figur 9 zeigt schließlich das entstandene Halbzeug nach dem Entfernen des Trägers 7. Hierzu kann die Diamantschicht 20 mit dem Substrat 10 erwärmt werden, um die Haltekräfte zwischen einem Wachs bzw. einem Klebstoff oder einem Lot und dem Träger 7 soweit zu reduzieren, dass der Träger beschädigungsfrei abgenommen werden kann. Daran kann sich ein optionaler Reinigungsschritt anschließen, um eine saubere Oberfläche der Diamantschicht 20 sicher zu stellen.Die Reinigung kann in einem Ultraschallbad oder einem Plasma erfolgen.

Das erfindungsgemäße Halbzeug kann in nachfolgenden Verfahrensschritten weiter verarbeitet werden, um eine integrierte optischen Komponente herzustellen. Hierzu zeigt Figur 10 das Aufbringen eines Photolackes 80. Der Photolack 80 kann aus einem Polymer bestehen oder ein solches enthalten. Der Photolack 80 kann beispielsweise durch Spin-Coaten, Drucken, Rakeln oder andere, an sich bekannte Verfahren aufgebracht werden.

Nach dem Aushärten des Photolackes 80 kann dieser durch Belichten mittels einer Maske und nachfolgendes Entwickeln und Ätzen strukturiert werden, so dass sich erste Teilflächen ergeben, welche mit dem Photolack bedeckt sind und zweite Teilflächen 81 verbleiben, von welchen der Photolack entfernt ist. Dies ist in Figur 11 dargestellt.

Nachfolgend wird das Substrat 10 mit einer Metallisierung 85 versehen, welche in Figur 12 dargestellt ist. Die Metallisierung 85 kann beispielsweise durch Sputtern eines reinen Metalltargets, durch thermisches Aufdampfen, durch Ionenplattieren oder andere, an sich bekannte Verfahren erzeugt werden. Die Metallisierung 85 kann eine Mehrzahl von Einzelschichten enthalten, welche beispielsweise zur Haftverbesserung verwendbar sind.

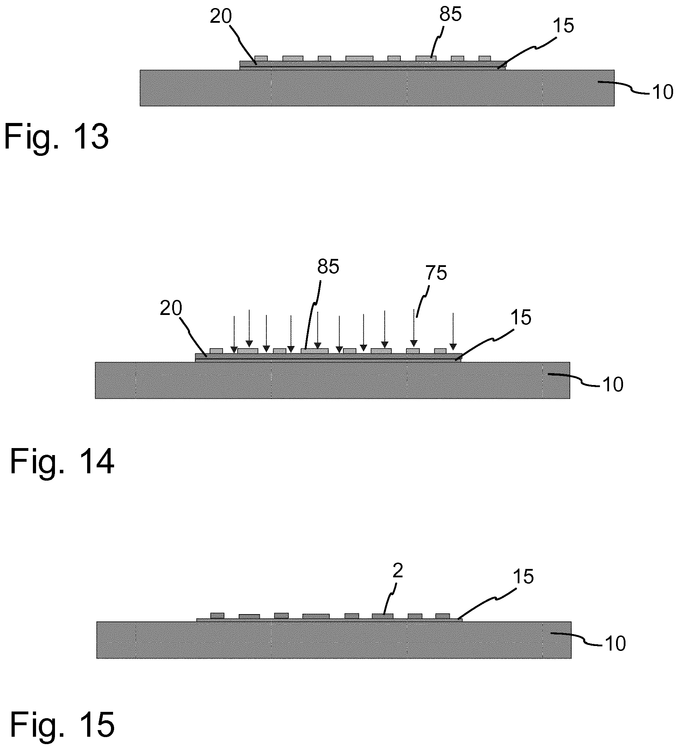

Figur 13 zeigt den Querschnitt durch das Substrat 10 und die Diamantschicht 20, nachdem der Photolack 80 entfernt wurde. Dies bewirkt darüber hinaus auch, dass die auf dem Photolack 80 befindliche Teilfläche der Metallisierung 85 entfernt wird, so dass nun Teilflächen der Diamantschicht 20 freiliegen und andere Teilflächen der Diamantschicht 20 mit der Metallisierung 85 bedeckt sind.

Wie in Figur 14 erläutert wird, folgt daraufhin wiederum ein nass- oder trockenchemisches Ätzen. In einigen Ausführungsformen der Erfindung kann das Ätzen durch ein Plasma erfolgen. Das Plasma kann Sauerstoff oder ein Gemisch aus Argon und Sauerstoff enthalten oder daraus bestehen. Das Ätzmittel 75 greift somit die unbedeckten Teilflächen der Diamantschicht 20 an. Die von der Metallisierung 85 geschützten Teilflächen werden hingegen vom Ätzmittel 75 nicht angegriffen.

Figur 15 zeigt den Querschnitt durch den Wafer nach Entfernen der Metallisierung 85. Zu diesem Zeitpunkt sind somit auf dem Substrat 10 Wellenleiter 2 oder andere mikrooptische Bauteile angeordnet, welche aus einkristallinen Diamant mit hoher Kristallqualität bestehen. Das einkristalline, defektarme Material des Diamants 20 weist gegenüber polykristallinem Diamant eine geringe Defektdichte auf, so dass innerhalb des Wellenleiters 2 propagierendes Licht eine geringere Schwächung erfährt.

Selbstverständlich ist die Erfindung nicht auf die dargestellten Ausführungsformen beschränkt. Die vorstehende Beschreibung ist daher nicht als beschränkend, sondern als erläuternd anzusehen. Die nachfolgenden Ansprüche sind so zu verstehen, dass ein genanntes Merkmal in zumindest einer Ausführungsform der Erfindung vorhanden ist. Dies schließt die Anwesenheit weiterer Merkmale nicht aus. Sofern die Ansprüche und die vorstehende Beschreibung "erste" und "zweite" Aus-führungsformen definieren, so dient diese Bezeichnung der Unterscheidung zweier gleichartiger Ausführungsformen, ohne eine Rangfolge festzulegen.

## Patentansprüche

1. Halbzeug (1) mit einem Substrat (10) mit einer ersten Seite (11) und einer gegenüberliegenden zweiten Seite (12), wobei auf der ersten Seite zumindest eine Diamantschicht (20) angeordnet ist, **dadurch gekennzeichnet, dass** die Diamantschicht (20) einkristallinen Diamant enthält oder daraus besteht und das Substrat (10) ein von der Diamantschicht (20) verschiedenes Material enthält oder daraus besteht.

2. Halbzeug nach Anspruch 1, **dadurch gekennzeichnet, dass** die Diamantschicht (20) eine Dicke von etwa 1 µm bis etwa 6 µm oder von etwa 2 µm bis etwa 5 µm aufweist und/oder dass das die Diamantschicht eine Fläche zwischen etwa 450 mm³ und etwa 45000 mm³ aufweist.

3. Halbzeug nach Anspruch 1 oder 2, **dadurch gekennzeichnet, dass** das Substrat (10) ein Oxid und/oder ein Nitrid und/oder Siliziumoxid und/oder Siliziumnitrid und/oder Siliziumoxinitrid und/oder Siliziumcarbid und/oder Silizium und/oder Saphir und/oder Glas und/oder einen III-VI-Verbindungshalbleiter und/oder Aluminiumnitrid enthält oder daraus besteht.

4. Halbzeug nach einem der Ansprüche 1 bis 3, **dadurch gekennzeichnet, dass** zwischen dem Substrat (10) und der Diamantschicht (20) eine Isolationsschicht (15) angeordnet ist.

5. Halbzeug nach einem der Ansprüche 1 bis 4, **dadurch gekennzeichnet, dass** die Verbindung zwischen der Diamantschicht (20) und dem Substrat (10) durch direktes Waferbonden oder oberflächenaktiviertes Bonden oder Plasma-aktiviertes Bonden oder Löten oder Kleben hergestellt ist.

6. Halbzeug nach einem der Ansprüche 1 bis 5, **dadurch gekennzeichnet, dass** im Substrat (10) zumindest ein elektronisches oder optoelektronsiches Bauelement (4) angeordnet ist und/oder
dass das Substrat (10) aus einer Mehrzahl von Einzelschichten besteht.

7. Halbzeug nach Anspruch 6, **dadurch gekennzeichnet, dass** das Bauelement ausgewählt ist aus zumindest einer Leiterschleife und/oder zumindest einer Antenne (40) und/oder zumindest einem Transistor und/oder zumindest einer Kapazität und/oder zumindest einem Widerstand und/oder zumindest einem optoelektronischen Bauteil.

8. Integrierte optische Komponente hergestellt aus zumindest einem Halbzeug nach einem der Ansprüche 1 bis 7.

9. Integrierte optische Komponente nach Anspruch 8, **dadurch gekennzeichnet, dass** die Diamantschicht (20) strukturiert ist, um zumindest ein Bauelement zu bilden, welches ausgewählt ist aus einem Wellenleiter und/oder einem Laser und/oder einem Verstärker und/oder einem MMI und/oder einem Mischer und/oder einem Frequenzvervielfacher und/oder einem optisch-parametrischen Oszillator und/oder einem Interferometer.

10. Verfahren zur Herstellung eines Halbzeuges, enthaltend folgende Schritte:
homoepitaktisches Herstellen einer einkristallinen Diamantschicht (20) auf einem Hilfssubstrat (25),
Ablösen der Diamantschicht (20) vom Hilfssubstrat (25),
Aufbringen der Diamantschicht (20) auf ein Substrat (10), welches ein von der Diamantschicht (20) verschiedenes Material enthält oder daraus besteht.

11. Verfahren nach Anspruch 10, **dadurch gekennzeichnet, dass** das Aufbringen der Diamantschicht (20) auf das Substrat (10) durch direktes Waferbonden oder Oberflächenaktiviertes Bonden oder Plasma-aktiviertes Bonden oder Löten oder Kleben erfolgt.

12. Verfahren nach einem der Ansprüche 10 oder 11, **dadurch gekennzeichnet, dass** die Diamantschicht (20) vor dem Ablösen vom Hilfssubstrat (25) auf einem Träger (7) befestigt wird.

13. Verfahren nach einem der Ansprüche 10 bis 12, **dadurch gekennzeichnet, dass** das Substrat (10) ein Oxid und/oder ein Nitrid und/oder Siliziumoxid und/oder Siliziumnitrid und/oder Siliziumoxinitrid und/oder Siliziumcarbid und/oder Silizium und/oder Saphir und/oder Glas und/oder einen III-VI-Verbindungshalbleiter und/oder Aluminiumnitrid enthält oder daraus besteht

14. Verfahren nach einem der Ansprüche 10 bis 13, **dadurch gekennzeichnet, dass** die Diamantschicht (20) eine Dicke von etwa 1 µm bis etwa 6 µm oder von etwa 2 µm bis etwa 5 µm aufweist und/oder
dass das die Diamantschicht eine Fläche zwischen etwa 450 mm³ und etwa 45000 mm³ aufweist

15. Verfahren nach einem der Ansprüche 12 bis 14, **dadurch gekennzeichnet, dass** der Träger (7) durch Wachs oder Klebstoff oder eine Lötverbindung befestigt wird und/oder dass nach Entfernen des Trägers ein Reinigungsschritt erfolgt.
